# EUROPÄISCHE PATENTANMELDUNG

(11) **EP 0 845 921 A1**
(43) Veröffentlichungstag der Anmeldung: **03.06.1998**
(21) Anmeldenummer: 96117024.8
(22) Anmeldetag: 23.10.1996
(51) Int. Cl.: H04R 25/00, H03G 3/30

(54) **Verfahren und Schaltung zur Verstärkungsregelung in digitalen Hörgeräten**

(71) Anmelder: Siemens Audiologische Technik GmbH, 91058 Erlangen (DE)
(72) Erfinder: Sigwanz, Ullrich, Dipl.-Ing., 91058 Erlangen (DE); Zöls, Fred, Dipl.-Ing.(FH), 90592 Altenthann (DE)
(74) Vertreter: Fuchs, Franz-Josef, Dr.-Ing.

(57) **Zusammenfassung**

Die Erfindung betrifft ein Verfahren zur Signalverstärkung in digitalen Hörgeräten, insbesondere in Hörgeräten mit automatischer Verstärkungsregelung (AGC), wobei zunächst eine Digitalisierung eines Eingangssignals aus dem Signalpfad des Hörgeräts, daraufhin eine Gleichrichtung von Abtastwerten des digitalisierten Eingangssignals, im folgenden eine Ermittlung von zu den Abtastwerten zugeordneten Verstärkungswerten, daraufhin eine Glättung der Verstärkungswerte und schließlich, nach vorausgehender Zuordnung der geglätteten Verstärkungswerte zu den Abtastwerten, eine Ausgabe der reanalogisierten zugeordneten Werte in den Signalpfad des Hörgerätes erfolgt. Ferner betrifft die Erfindung eine Schaltung zur Signalverstärkung in digitalen Hörgeräten, insbesondere in digitalen Hörgeräten mit automatischer Verstärkungsregelung (AGC).

## Beschreibung

Die Erfindung betrifft ein Verfahren und eine Schaltung zur Signalverstärkung in digitalen Hörgeräten, insbesondere in Hörgeräten mit automatischer Verstärkungsregelung (AGC).

Als Stand der Technik ist es bekannt, in digitalen Hörgeräten zur Verstärkung von Eingangssignalen Algorithmen anzuwenden, welche das Lade- und Entladeverhalten eines AGC-Kondensatorelements in einem analogen Hörgerät simulieren. Hierbei werden die von analogen Eingangssignalwerten durch Digitalisierung gewonnenen Abtastwerte mit einem gespeicherten mittleren Abtastwert verglichen und gegebenenfalls bei der Abweichung von diesem mittleren Abtastwert geglättet. Hierdurch wird die Welligkeit der Abtastwerte verringert. Daraufhin werden den geglätteten Abtastwerten korrespondierende abgespeicherte Verstärkungswerte zugeordnet. Durch Verknüpfung dieser Verstärkungswerte mit den eventuellen vorverarbeiteten abgetasteten Signalwerten lassen sich verschiedenartige Signalkompressionen, -Expansionen oder eine Kombination aus beiden erzeugen. Nach Reanalogisierung des abgetasteten digitalen Signals ergibt sich ein entsprechend verstärktes Ausgangssignal.

Bei einer derartigen Glättung und darauffolgenden Verstärkung des Eingangssignals ist jedoch durch die nicht vermeidbare Stufung der Verstärkungswerte ein erheblicher und unerwünschter Anstieg des Klirrfaktors des Ausgangssignals gegenüber dem Eingangssignal festzustellen.

Der Erfindung liegt die Aufgabe zugrunde, ein Verfahren sowie eine Schaltung zur Signalverstärkung in digitalen Hörgeräten anzubieten, bei welchen der Klirrfaktor im wesentlichen unverändert bleibt.

Die Aufgabe wird für das Verfahren durch die Verfahrensschritte nach Patentanspruch 1 gelöst. Vorteilhafte Verfahrensvarianten werden durch die Unteransprüche 2 - 13 realisiert.

Hinsichtlich der Schaltung wird die Aufgabe durch Patenanspruch 14 gelöst.

Das erfindungsgemäße Verfahren erfaßt zunächst ein abgetastetes Eingangssignal aus dem Signalpfad des Hörgerätes und richtet dieses z.B. durch Betragsbildung oder Quadrieren gleich. Zur Signalverstärkung werden nun den Abtastwerten korrespondierende Verstärkungswerte zugeordnet. Nach Transformation des abgetasteten Eingangssignals in eine Reihe von Verstärkungswerten erfolgt nun eine Glättung der Verstärkungswerte. Die sich ergebenden geglätteten Verstärkungswerte werden nun mit den Abtastwerten verknüpft, analogisiert und als Ausgangssignal in den Signalpfad des Hörgerätes zurückgeleitet.

Das derartig gegenüber dem Eingangssignal verstärkte Ausgangssignal weist einen im Vergleich zum Eingangssignal im wesentlichen unveränderten Klirrfaktor auf, so daß eine verzerrungsfreie automatische Signalverstärkungsregelung sichergestellt ist.

Beim Stand der Technik erfolgt eine Glättung des Signals vor der Bestimmung der Verstärkung. Da den einzelnen Abtastwerten des geglätteten Eingangssignals korrespondierende abgestufte Verstärkungswerte zugeordnet werden, treten bei der Verstärkung der Abtastwerte in Abhängigkeit von der Feinheit der Stufung der Verstärkungswerte mehr oder weniger große Verstärkungssprünge auf, welche zu einer Signaldeformation und damit zu einer unerwünschten Erhöhung des Klirrfaktors führen.

Das erfindungsgemäße Verfahren erreicht durch die Glättung der den gleichgerichteten Abtastwerten zugeordneten Verstärkungswerten eine Signalverstärkung mit im wesentlichen/oder völlig unverändertem Klirrfaktor, obwohl trotz nicht geglättetem Eingangssignal stark schwankende Abtastwerte und zugehörige Verstärkungswerte auftreten. Durch die nachfolgende Glättung der Verstärkungswerte wird jedoch überraschenderweise die angestrebte Verstärkung ohne deutliche Klirrfaktorerhöhung erzielt.

Vorteilhafterweise sind die den gleichgerichteten Abtastwerten zugeordneten korrespondierenden Verstärkungswerte in einem Datenspeicher abgelegt. Eine neuartige Verstärkungscharakteristik kann somit einfach durch Abspeicherung entsprechend modifizierter Verstärkungswerte im Datenspeicher erfolgen.

Die durch die Erfindung realisierte Verstärkung ohne Veränderung des Klirrfaktors wird bereits bei einer Abspeicherung von nur ca. 16 den jeweiligen gleichgerichteten Abtastwerten zugeordneten Verstärkungswerten im Datenspeicher erreicht.

Damit wird nur eine geringe Speicherkapazität benötigt, und eine neue Speicherung zur Realisierung einer gewünschten Verstärkungscharakteristik kann mit geringen Zeitaufwand erfolgen.

Zur Realisierung individueller und verfeinerter Verstärkungscharakteristiken kann es vorteilhaft sein im Datenspeicher eine wesentlich größere Anzahl von den jeweiligen Abtastwerten zugeordneten Verstärkungswerten abzuspeichern, wodurch eine Optimierung des erfindungsgemäßen Verfahrens realisiert wird.

Vorteilhafterweise sind die Verstärkungswerte den Abtastwerten über einen Algorithmus zur automatischen Verstärkungsregelung (Automatic Gain Control, AGC) zugeordnet, so daß beispielsweise im mittleren und höheren Eingangspegelbereich eine geringere Verstärkung realisiert wird.

Zur Einhaltung des Shannonschen Abtasttheorems kann es vorteilhaft sein, vor der Ermittlung der Verstärkungswerte nach Schritt b) von Patentanspruch 1 ein Quadrieren und Glätten der digitalen Abtastwerte vorzunehmen.

In einer weiteren vorteilhaften Verfahrensweise ist zwischen dem Ausschwingen eines vorhergehenden Verstärkungswertes und dem Einschwingen des nachfolgenden Verstärkungswertes eine Totzeit vorzusehen, um ein unerwünschtes Übergreifen des Ausschwingbereichs des vorhergehenden Verstärkungswertes in den Einschwingbereich des nachfolgenden Verstärkungswertes (z.B. bei Sinussignalen mit konstantem Pegel) zu vermeiden.

Eine zuverlässige Trennung von Ausschwingvorgang und darauffolgendem Einschwingvorgang wird erreicht, wenn die zwischen zwei Verstärkungswerten angeordnete Totzeit mindestens der halben Periodendauer der niedrigsten Frequenz des Eingangssignal entspricht. Durch laufende Frequenzanalyse oder entsprechende Bandbegrenzung des Eingangssignals können die entsprechenden Totzeiten in Anpassung an die niedrigste Frequenz des Eingangssignals individuell angepaßt werden.

Zur individuellen Anpassung an die jeweilige Charakteristik des Eingangssignals sind die Einschwingzeiten, Ausschwingzeiten und Totzeiten, die den einzelnen Verstärkungswerten zugeordnet werden können, individuell einstellbar. Dies kann beim Programmieren des Hörgeräts, aber auch durch den Benutzer des Hörgeräts selbst erfolgen.

Eine weitere Verbesserung des Klangeindrucks ergibt sich, wenn die Totzeit zwischen Ausschwing- und Einschwingzeiten der einzelnen Verstärkungswerte bei Überschreitung eines Grenzwertes durch den Pegel Eingangssignals vermindert wird.

Ein besonders angenehmer Klangeindruck stellt sich ferner ein, wenn die Einschwingzeit der Verstärkungswerte sich nicht unterhalb von 1 ms befindet. Bei kürzeren Einschwingzeiten wird der Klangeindruck vom Benutzer oftmals als unangenehm empfunden.

Zur Vermeidung des Überschwingens bei mittleren oder längeren Einschwingzeiten werden die Abtastwerte den Verstärkungswerten vorteilhafterweise verzögert zugeordnet. Damit kann jedem Verstärkungswert die entsprechende längere Einschwingzeit ermöglicht werden, und erst nach vollständigem Einschwingen des

Verstärkungswertes wird dieser dem abgetastetem Signalwert zugeordnet. Durch geeignete Wahl der Anzahl der Pufferelemente für die Verzögerungsleitung für die abgetasteten Signalwerte kann ein Kompromiß zwischen Gesamtverzögerungszeit des Systems und der Größe des Überschwingens getroffen werden.

Zur Zurückhaltung und verzögernder Zuordnung der Signalwerte zu den Verstärkungswerten wird vorteilhafterweise ein Pufferelement, insbesondere ein Ringpuffer, verwendet, wobei sich eine Speicherkapazität des Pufferelementes von 16 Werten für die meisten Anwendungsfälle als ausreichend erwiesen hat.

Einzelheiten und Vorteile der erfindungsgemäßen Schaltung werden im Ausführungsbeispiel näher erläutert.

Die Erfindung ist anhand von Ausführungsbeispielen hinsichtlich des Verfahrens sowie der Schaltung näher erläutert. Ferner wird ein beispielhafter Glättungsalgorithmus vorgestellt. Die Abbildungen zeigen:
- FIG. 1: einen Ablaufplan des erfindungsmäßigen Verfahrens,
- FIG. 2: ein Prinzipschaltbild der erfindungsmäßigen Schaltung,
- FIG. 3: einem Vergleich des Schwingungsverhaltens zwischen dem erfindungsgemäßen Verfahren und einem bislang bekannten Verfahren
- FIG. 4: einen Vergleich der Glättung zwischen dem erfindungsgemäßen Verfahren sowie
- FIG. 5a/FIG. 5b: eine Darstellung von Einschwing-, Ausschwing- und Totzeiten

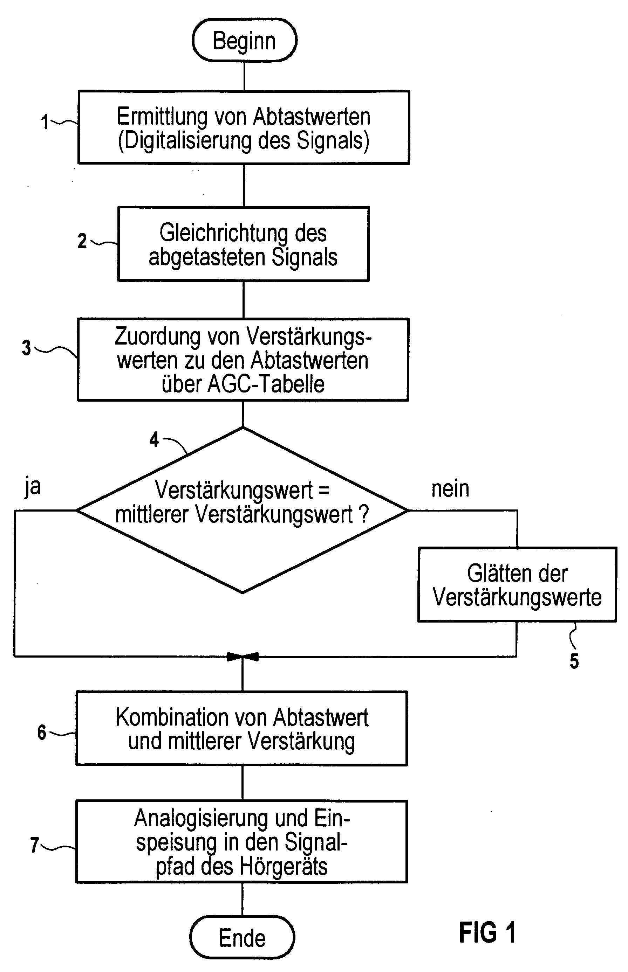

Der Ablaufplan nach FIG. 1 umfaßt 7 Verfahrensschritte und schildert ausgehend von der Abtastung des analogen Eingangssignals (Schritt 1), die Gleichrichtung (Schritt 2), die Zuordnung zu den ermittelten Abtastwerten ausgehend von einer AGC-Tabelle, welche nach einer bestimmten AGC-Charakteristik abgestufte Verstärkungswerte enthält (Schritt 3).

In Schritt 4 erfolgt für jeden Verstärkungswert ein Vergleich mit dem vorher abgespeicherten oder im Verlauf des Verfahrens mittleren Verstärkungswert. Eine Glättung der Verstärkungswerte erfolgt nach Schritt 5 dann, wenn die jeweiligen Verstärkungswerte von den mittleren Verstärkungswerten abweichen.

Schließlich wird in Schritt 7 das analoge Ausgangssignal als Analogisierung der Kombination der Abtastwerte und der geglätteten Verstärkungswerte (Schritt 6) ausgegeben.

In FIG. 1 ist die mögliche Zwischenspeicherung der Abtastwerte (nach Schritt 1) durch ein Pufferelement nicht aufgeführt.

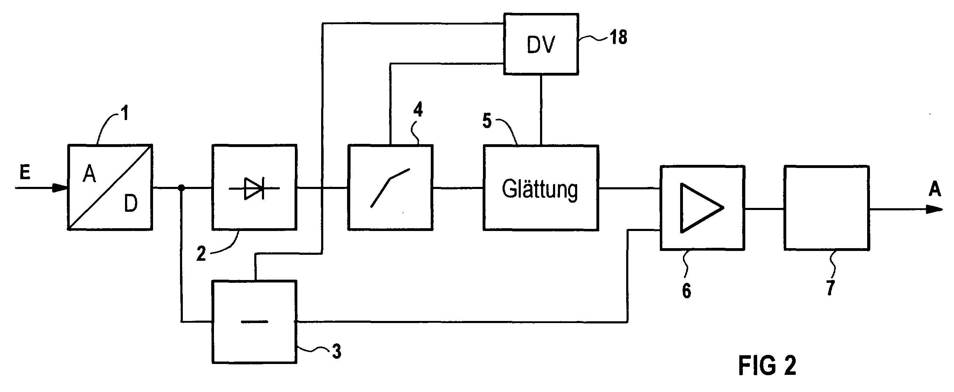

Das Prinzipschaltbild nach FIG. 2 geht von einem Eingangssignal E aus, welches durch einen A/D-Wandler 1 zur Ermittlung von Abtastwerten digitalisiert wird. Die Abtastwerte werden einerseits in einem Pufferelement 3 zur Zwischenspeicherung abgelegt andererseits durch Betragsbildung oder Quadrieren durch ein Gleichrichterelement 2 gleichgerichtet. Diesen gleichgerichteten Signalwerten werden über ein Zuordnungselement 4, insbesondere über in einer AGC-Tabelle abgelegte Zuordnungen, Verstärkungswerte zugeordnet.

Die zugeordneten Verstärkungswerte werden daraufhin im Glättungselement 5 geglättet und mit den verzögerten Abtastwerten mittels eines Kombinationselements 6 verknüpft. Nach Analogisierung des abgetasteten Signals durch einen Wandler 7 zur Analogisierung der digitalen Werte steht dann ein verstärktes Signal A zur Verfügung, wobei der Klirrfaktor des Signals nach Verstärkung im wesentlichen unverändert bleibt.

Über die DV-Einheit 18, welche zur Steuerung des Zuordnungselements 4, des Pufferelements 3 und des Glättungselements 5 eingesetzt ist, können angepaßte Algorithmen zur Verstärkung und zur Glättung eingegeben werden sowie Parameter, wie z.B. Dauer der Zwischenspeicherung im Pufferelement, Einschwingzeit, Ausschwingzeit und Totzeit der Verstärkungswerte festgelegt werden.

Die Glättung der Verstärkungswerte im Glättungselement 5 kann durch an sich bekannte statistische Glättungsmethoden erfolgen.

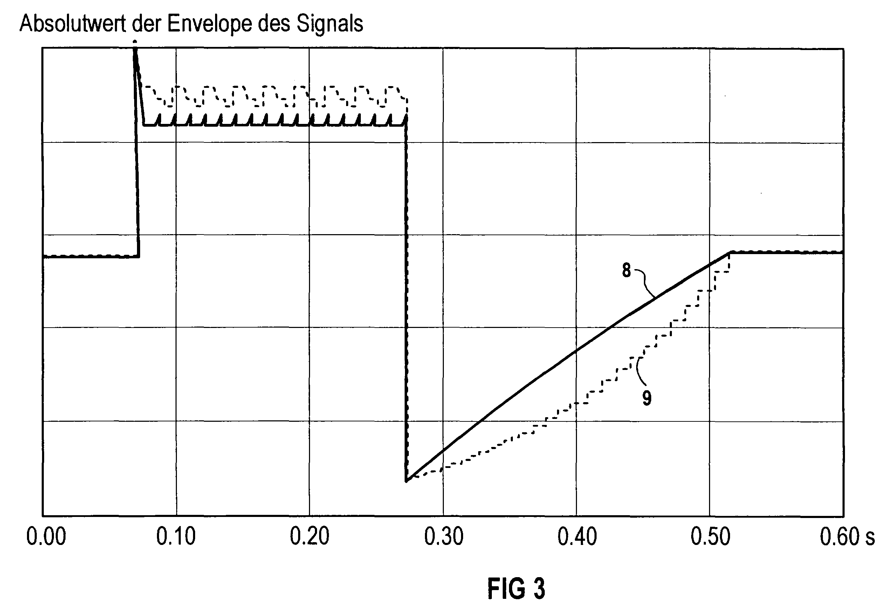

FIG. 3 zeigt ausgehend von einem Sinusimpuls ( 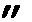 Sinusburst") durch Auftragung des Absolutwerts der Envelope des verarbeiteten Signals über der Zeit die im Gegensatz zur herkömmlichen Signalverarbeitung (nach Modell des simulierten Ladekondensators) nach Signalverlauf 9 von Verstärkungssprüngen freie Signalverstärkung nach Verlauf 8 (siehe z.B. zwischen 0,30 und 0,50 s).

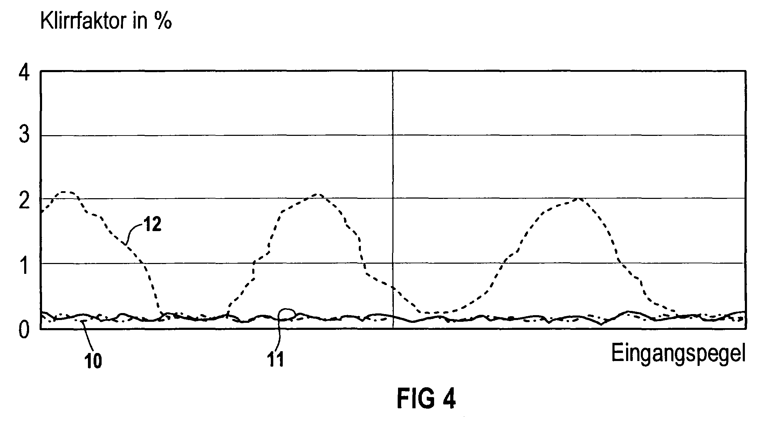

Die vorteilhafte Glättungswirkung des erfindungsgemäßen Verfahrens geht auch aus FIG. 4 hervor, in welcher der Klirrfaktor über dem Eingangspegel bei statischer Verstärkung aufgetragen ist. Im Gegensatz zur praktisch klirrfaktorfreien Verstärkung durch das erfindungsgemäße Verfahren nach Signalverlauf 10 (16 Stufen der AGC-Tabelle) und nach Signalverlauf 11 (64 Stufen der AGC-Tabelle) werden bei konventionellen Verfahren nur Klirrfaktorwerte von über 2% erreicht.

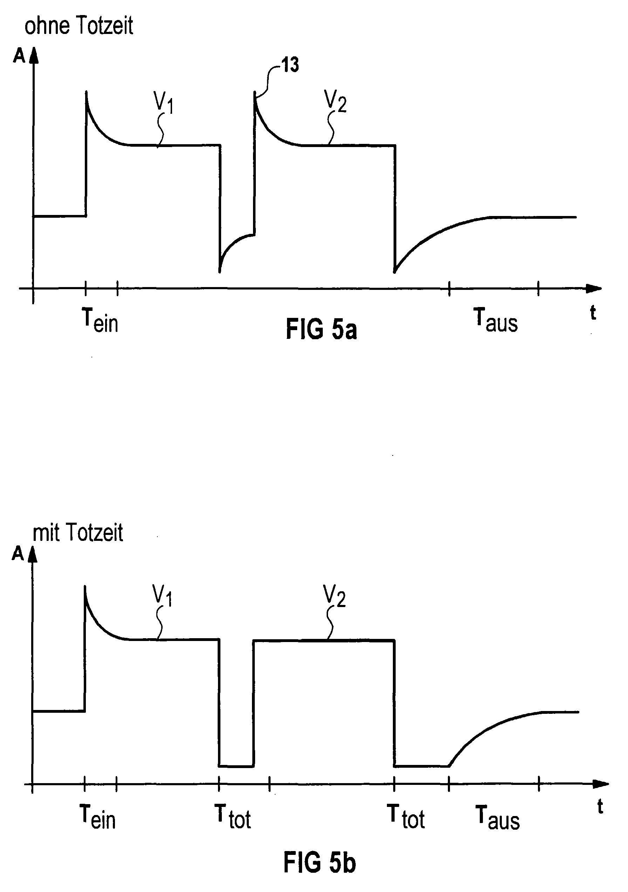

In FIG. 5a (ohne Totzeit) und FIG. 5b (mit Totzeit) sind zwei Verstärkungswerte V₁ und V₂ über der Zeit aufgetragen. Zwischen V₁ und V₂ bewirkt die Totzeit Tₜₒₜ eine zuverlässige Trennung der Schwingungsbereiche V₁ und V₂ (FIG. 5b). Damit tritt allein am Anfang des ersten Verstärkungswertes V₁ eine Einschwingzeit Tₑᵢₙ und am Ende eines abschließenden Verstärkungswertes V₂ eine Ausschwingzeit Tₐᵤₛ ein (FIG. 5b). In FIG. 5a tritt zwischen V₁ und V₂ ein gestörter Übergang mit Schwingungsspitze 13 am Anfang von V₂ auf.

Im folgenden wird eine Glättung eines Verstärkungswertes anhand eines dimensionslosen Zahlenbeispiels verdeutlicht.

Es wird in der Terminologie von einer fiktiven Glättung mittels Glättungskondensator ausgegangen, wobei der Glättungskondensator eine fiktive Ladekonstante sowie eine fiktive Entladekonstante aufweist.

Ausgegangen wird von folgenden Größen:
Verstärkungswert = 6
Mittelwert₁ = 4
fiktive Ladekonstante = 0,1
fiktive Entladekonstante = 0,2

Der Glättungsalgorithmus für eine Veränderung der Verstärkung zu größeren Werten besteht aus den Gleichungen (1) - (3):
(1) Differenz₁ =
   Verstärkungswert - Mittelwert₁ = 6 - 4 = 2
(2) fiktiver Ladebeitrag =
   fiktive Ladekonstante x Differenz₁ = 0,1 x 2 = 0,2
(3) Mittelwert₂ =
   Mittelwert₁ + fiktiver Ladebeitrag = 4 + 0,2 = 4,2
   Ausgehend vom Verstärkungswert 6 ergibt sich der geglättete Verstärkungswert 4,2.
   Geht man von folgenden Größen aus:
   Verstärkungswert = 3
   Mittelwert₁ = 4,2
   fiktive Ladekonstante = 0,1
   fiktive Entladekonstante = 0,2,
   so bewirkt dies eine Glättung in Richtung kleinerer Verstärkungen, was durch die Gleichungen (4) - (6) beschrieben wird.
(4) Differenz₁ =
   Verstärkungswert - Mittelwert₁ = 3 - 4,2 = -1,2
(5) fiktiver Entladebeitrag =
   fiktive Entladekonstante x Differenz₁ = 0,2 x -1,2 = -0,24
(6) Mittelwert₂ =
   Mittelwert₁ + fiktiver Entladebeitrag = 4,2 - 0,24 = 3,96

Hier wurde ausgehend vom Verstärkungswert 3 der geglättete Verstärkungswert 3,96 ermittelt.

## Patentansprüche

1. Verfahren zur Signalverstärkung in digitalen Hörgeräten, insbesondere in Hörgeräten mit automatischer Verstärkungsregelung (AGC),
mit folgenden Verfahrensschritten:
a) Ermittlung von digitalen Abtastwerten eines Eingangssignals aus dem Signalpfad des Hörgeräts,
b) Gleichrichtung der Abtastwerte (z.B. durch Quadrieren oder Betragsbildung),
c) Zuordnung von Verstärkungswerten zu den ermittelten Werten aus b),
d) Glättung der Verstärkungswerte nach c),
e) Kombination der Abtastwerte nach a) mit den Verstärkungswerten nach d),
f) Ausgabe der analogisierten kombinierten Werte nach e) in den Signalpfad des Hörgerätes

2. Verfahren nach Anspruch 1,
**dadurch gekennzeichnet**, daß die den Abtastwerten zugeordneten Verstärkungswerte und/oder die Zuordnungen zu den Abtastwerten in einem Datenspeicher abgelegt sind.

3. Verfahren nach Anspruch 2,
**dadurch gekennzeichnet**, daß der Datenspeicher eine wählbare Anzahl (insbesondere 16) an Abtastwerten und jeweils zugeordneten Verstärkungswerten umfaßt.

4. Verfahren nach einem der vorgehenden Ansprüche,
**dadurch gekennzeichnet**, daß die Verstärkungswerte den Abtastwerten über einen Algorithmus zur automatischen Verstärkungsregelung (Automatic Gain Control, AGC) zugeordnet sind.

5. Verfahren nach einem der vorgehenden Ansprüche,
**dadurch gekennzeichnet**, daß vor der Ermittlung der Verstärkungswerte nach Schritt b) von Patentanspruch 1 eine Glättung des gleichgerichteten Signals erfolgt.

6. Verfahren nach einem der vorgehenden Ansprüche,
**dadurch gekennzeichnet**, daß zwischen dem Ende einer vorhergehenden Verstärkung V₁ und dem Beginn einer darauffolgenden Verstärkung V₂ eine Totzeit vorgesehen ist.

7. Verfahren nach Anspruch 6,
**dadurch gekennzeichnet**, daß die Totzeit mindesten der halben Periodendauer der niedrigsten Frequenz des Eingangssignals entspricht.

8. Verfahren nach Anspruch 6 oder 7,
**dadurch gekennzeichnet**, daß die Einschwingzeit und/oder Ausschwingzeit und/oder Totzeit eines Verstärkungswertes vorgebbar sind.

9. Verfahren nach einem der Ansprüche 6 - 8,
**dadurch gekennzeichnet**, daß die Totzeit bei Überschreitung eines Grenzwertes des Eingangspegels vermindert wird.

10. Verfahren nach einem der Ansprüche 6 - 9,
**dadurch gekennzeichnet**, daß die Einschwingzeit eines Verstärkungssignalwertes in der Größenordnung von 1,0 - 1,5 ms liegt.

11. Verfahren nach einem der vorhergehenden Ansprüche,
**dadurch gekennzeichnet**, daß die Zuordnung von Abtastwerten zu den Verstärkungswerten zur Ermöglichung einer längeren Einschwingzeit der Verstärkungswerte verzögert erfolgt.

12. Verfahren nach Anspruch 11,
**dadurch gekennzeichnet**, daß zur verzögernden Zwischenspeicherung der Abtastwerte ein Pufferelement (3) vorgesehen ist.

13. Verfahren nach Anspruch 12,
**dadurch gekennzeichnet**, daß die Speicherkapazität des Pufferelements (3) an die Einschwingzeit anpaßbar ist.

14. Schaltung zur Signalverstärkung in digitalen Hörgeräten, insbesondere in digitalen Hörgeräten mit automatischer Verstärkungsregelung (AGC), insbesondere zur Durchführung eines Verfahrens nach einem der Ansprüche 1 - 13,
**mit folgenden Merkmalen**:
- einem A/D-Wandler (1) zur Ermittlung von Abtastwerten des analogen Eingangssignals E,
- einem Gleichrichterelement (2) zur Gleichrichtung des digitalisierten Eingangssignals,
- einem Pufferelement (3) zur verzögernden Zwischenspeicherung der Abtastwerte,
- einem Zuordnungselement (4) zur Zuordnung der Verstärkungswerte zu den Abtastwerten,
- einem Glättungselement (5) zur Glättung der Verstärkungswerte,
- einem Kombinationselement (6) zur Kombination der geglätteten Verstärkungswerte und der verzögerten Abtastwerte,
- einem Wandler (7) zur Analogisierung der digitalen verstärkten Abtastwerte sowie
- einer DV-Einheit (18) zur Steuerung des Zuordnungselements (4), des Pufferelements (3) und des Glättungselements (5).
